# DEMANDE DE BREVET EUROPEEN

(11) **EP 4 249 632 A1**
(43) Date de publication de la demande: **27.09.2023**
(21) Numéro de dépôt: 23160228.5
(22) Date de dépôt: 06.03.2023
(51) Int. Cl.: C23C 16/455, C23C 16/448, G21C 3/04, B05B 1/20, B05D 1/02, G21C 3/07, G21C 3/20, C23C 16/04

(54) **DISPOSITIF DE DIFFUSION D'UN PRÉCURSEUR À CONTENANT AYANT AU MOINS UN ÉLÉMENT POREUX PERMETTANT LA GÉNÉRATION D'UN AÉROSOL VERS UNE SURFACE DE CROISSANCE**

(30) Priorité: 24.03.2022 FR 2202614
(71) Demandeur: COMMISSARIAT À L'ÉNERGIE ATOMIQUE ET AUX ÉNERGIES ALTERNATIVES, 75015 Paris (FR)
(72) Inventeur: MASKROT, Hicham, 91310 Monthléry (FR); MICHAU, Alexandre, 91440 Bures-sur-Yvette (FR); HERCHER, Olivier, 91640 FONTENAY-LES-BRIIS (FR)
(74) Mandataire: Germain Maureau

(57) **Abrégé**

L'invention concerne un dispositif de diffusion (1) d'un précurseur configuré pour diffuser un précurseur de croissance vers une surface de croissance (s101) externe comprise sur un organe de croissance (100) externe, ledit dispositif de diffusion (1) comprenant un contenant (10) comprenant au moins un élément poreux (30) présentant une porosité configurée pour permettre ou empêcher à un fluide précurseur (15) de traverser une épaisseur (e31) de l'élément poreux (30), l'élément poreux (30) étant configuré de sorte que le fluide précurseur (15) qui traverse l'épaisseur (e31) de l'élément poreux (30) génère un aérosol (17) par fragmentation du fluide précurseur (15), ledit aérosol (17) étant formé de gouttelettes du fluide précurseur (15).

L'invention concerne également un procédé de dépôt d'une couche (103) sur une surface de croissance (s101) par un tel dispositif de diffusion (1).

## Description

### Domaine technique de l'invention

La présente invention concerne un dispositif de diffusion d'un précurseur configuré pour diffuser un précurseur de croissance vers une surface de croissance externe comprise sur un organe de croissance externe.

L'invention concerne aussi un procédé de dépôt d'une couche sur une surface de croissance, le procédé de dépôt comprenant une étape de fourniture d'un tel dispositif de diffusion, dans lequel l'au moins une enceinte de réception est remplie au moins partiellement par un fluide précurseur.

### Etat de la technique

L'augmentation de la part des énergies renouvelables dans le mix énergétique mondial contribue à augmenter le caractère intermittent de la fourniture en énergie électrique. Ainsi, il est nécessaire de coupler ces sources d'énergie intermittentes avec des sources énergétiques tierces stables et flexibles, afin de compenser leur caractère intermittent. Dans le cas où ladite source énergétique tierce est une source électronucléaire, la compensation donne lieu à une augmentation du nombre de phases de transitoires de puissance, qui vont alors devenir plus fréquentes pour le parc électronucléaire.

Une telle augmentation des phases de transitoires de puissance ont un effet direct sur certains composants comme les pastilles de combustible et les gaines les accueillant. Il est en effet nécessaire de trouver une solution pour limiter la problématique dite de l'IPG (pour interaction pastille gaine).

Lors d'un incident ou accident entraînant une augmentation (généralisée ou locale) de puissance, l'IPG correspond à la mise en traction de la gaine des crayons de combustible sous l'effet de l'interaction avec la pastille de combustible, qui se dilate plus fortement que la gaine. Lorsque l'interaction entre la pastille et la gaine est essentiellement mécanique, on parle alors d'ImPG. L'ImPG est consécutive à un pulse de puissance, c'est-à-dire à une montée en puissance rapide, non suivie par un palier de maintien en puissance. Il convient alors, pour ces situations et pour des taux de combustion moyens ou élevés, de limiter la déformation de la gaine de combustible afin de prévenir la rupture de gaine, qui peut conduire à une dispersion de combustible dans le circuit primaire, en particulier en cas de transitoires d'insertion de réactivité.

Les incidents caractérisés par une rampe de puissance suivie d'un maintien en puissance présentent un risque de rupture de gaine dit IPG CSC-I. Il s'agit d'une corrosion sous contrainte assistée par l'iode, qui conduit à un percement sans risque de dispersion de combustible.

Il est connu de l'état de la technique de proposer une gaine disposant d'une couche interne permettant de limiter voire supprimer les effets de l'IPG. Cependant, le procédé le plus mature pour déposer une telle couche interne mène à de fortes hétérogénéités en épaisseur sur des longueurs centimétriques voire métriques.

### Objet de l'invention

La présente invention a pour but de proposer une solution qui réponde à tout ou partie des problèmes précités.

Ce but peut être atteint grâce à la mise en oeuvre d'un dispositif de diffusion d'un précurseur configuré pour diffuser un précurseur de croissance vers une surface de croissance externe comprise sur un organe de croissance externe, ledit dispositif de diffusion comprenant un contenant délimitant intérieurement au moins une enceinte de réception, le contenant étant au moins en partie constitué par au moins un élément poreux, ledit élément poreux délimitant intérieurement une surface intérieure, ladite surface intérieure délimitant au moins partiellement l'au moins une enceinte de réception, ledit élément poreux délimitant extérieurement une surface de diffusion destinée à être tournée vers la surface de croissance externe.

Ladite au moins une enceinte de réception étant configurée pour contenir un fluide précurseur comprenant ledit précurseur de croissance.

Le dispositif de diffusion comprenant le fluide précurseur contenu dans l'enceinte de réception.

Ledit élément poreux présentant une porosité configurée d'une part pour permettre audit fluide précurseur de traverser une épaisseur de l'élément poreux comptée entre ladite surface intérieure et ladite surface de diffusion tant qu'une pression du fluide précurseur contenu dans l'enceinte de réception est strictement supérieure à une pression seuil, d'autre part pour empêcher au fluide précurseur de traverser ladite épaisseur de l'élément poreux lorsque la pression du fluide précurseur contenu dans l'enceinte de réception est inférieure à ladite pression seuil, ladite pression seuil étant strictement supérieure à une pression externe régnant à l'extérieur du contenant.

L'élément poreux étant configuré de sorte que le fluide précurseur qui traverse l'épaisseur de l'élément poreux génère, à partir de la surface de diffusion, un aérosol par fragmentation du fluide précurseur.

Ledit aérosol étant formé de gouttelettes du fluide précurseur et contenu entre la surface de diffusion et la surface de croissance externe.

Les dispositions précédemment décrites permettent de proposer un dispositif de diffusion apte à générer un aérosol comprenant des gouttelettes d'un fluide précurseur au niveau d'une surface de croissance. De manière avantageuse, le dispositif de diffusion précédemment décrit permet de contrôler à la fois le type de fluide précurseur compris dans l'aérosol diffusé, et la quantité d'aérosol diffusé. Par ailleurs, il est possible de diffuser ledit aérosol localement à proximité de la surface de croissance. Ainsi, les éventuelles pertes de fluide précurseur sont limitées. Enfin, le dispositif de diffusion permet de diffuser le fluide précurseur sous forme de liquide ultra divisé ou gazeux de façon homogène sur toute la surface de croissance, évitant les inhomogénéités. La fragmentation du fluide précurseur permet d'améliorer son évaporation et sa réactivité, en particulier lorsqu'il est utilisé dans un procédé de dépôt chimique en phase vapeur dans un four de croissance chimique.

Le dispositif de diffusion peut en outre présenter une ou plusieurs des caractéristiques suivantes, prises seules ou en combinaison.

Selon un mode de réalisation, l'élément poreux comprend un matériau métallique. Par exemple, l'élément poreux est constitué d'un matériau métallique.

Selon un mode de réalisation, le matériau métallique de l'élément poreux est de l'acier.

Selon un mode de réalisation, le matériau métallique de l'élément poreux est à base de Nickel, d'Aluminium ou de Tungstène.

Selon un mode de réalisation, l'élément poreux est adapté pour résister à des pressions et températures utilisées dans un procédé de dépôt chimique en phase vapeur. Par exemple l'élément poreux est configuré pour rester intègre à des températures comprises entre 1000°C et 1500°C.

De cette manière, le dispositif de diffusion est adapté pour être utilisé dans un procédé de dépôt chimique en phase vapeur.

Selon un mode de réalisation, le dispositif de diffusion est configuré pour apporter un aérosol comprenant au moins un agent précurseur au niveau de la surface de croissance d'une manière permettant la croissance d'une couche sur la surface de croissance. Par exemple, ladite couche peut être une couche de protection. Avantageusement, le dispositif de diffusion permet de contrôler l'épaisseur de la couche de protection déposée sur la surface de croissance.

Selon un mode de réalisation, le fluide précurseur est liquide, par exemple, le fluide précurseur peut comprendre un agent précurseur solide dissout dans un solvant. Alternativement, le fluide précurseur peut comprendre un mélange d'un solvant et d'un agent précurseur liquide.

Selon un mode de réalisation, l'agent précurseur comprend l'oxyde de chrome Cr₂O₃.

Selon un mode de réalisation, le contenant est intégralement formé par l'élément poreux.

Selon un mode de réalisation, l'élément poreux est un média de filtration poreux obtenu par un procédé réalisé conformément à l'un des modes de réalisation décrits dans le document FR20/14263, dont le contenu est incorporé par référence dans les limites permises par la loi.

Selon un mode de réalisation, l'élément poreux comprend des pores ayant un diamètre moyen compris entre 2µm et 100µm.

Selon un mode de réalisation, la pression seuil est comprise entre 2.10⁵ Pa et 20.10⁵ Pa.

Selon un mode de réalisation, le dispositif de diffusion comprend au moins un organe de mise en pression configuré pour faire varier la pression du fluide précurseur à l'intérieur de l'enceinte de réception, de manière à placer le fluide précurseur à une pression supérieure à la pression seuil, pour permettre au fluide précurseur de traverser l'élément poreux, de la surface intérieure vers la surface de diffusion.

Selon un mode de réalisation, l'organe de mise en pression comprend une pompe pneumatique.

Selon un mode de réalisation, le contenant s'étend globalement le long d'un axe longitudinal et comprend une extrémité obturée et une extrémité d'admission de fluide distantes l'une de l'autre le long de l'axe longitudinal, l'élément poreux étant situé entre ces deux extrémités et l'enceinte de réception étant configurée pour recevoir le fluide précurseur au niveau de l'extrémité d'admission de fluide et être fermée au niveau de l'extrémité obturée.

Selon un mode de réalisation, l'au moins un organe de mise en pression est disposé au niveau de l'extrémité d'admission de fluide de l'élément poreux.

Selon un mode de réalisation, la surface de diffusion de l'élément poreux présente une première forme prismatique caractérisée par un premier profil de base, ladite première forme prismatique étant générée par la translation rectiligne dudit premier profil de base le long de l'axe longitudinal, et dans lequel la surface intérieure de l'élément poreux présente une deuxième forme prismatique caractérisée par un deuxième profil de base, ladite deuxième forme prismatique étant générée par la translation rectiligne dudit deuxième profil de base le long de l'axe longitudinal.

Selon un mode de réalisation, au moins une surface choisie parmi la surface de diffusion et la surface intérieure de l'élément poreux se présente sous la forme de tout ou partie d'une surface cylindrique.

Par « surface cylindrique » on entend mathématiquement une surface en trois dimensions engendrée par une droite génératrice qui se déplace selon une direction donnée en s'appuyant sur une ligne courbe fermée appelée directrice. Dans le cas présent, la directrice correspond au profil de la section de coupe du contenant au niveau de l'élément poreux tandis que la droite génératrice est orientée de manière parallèle à l'axe longitudinal.

Selon un mode de réalisation, la surface de diffusion est tubulaire.

Selon un mode de réalisation, la surface intérieure est tubulaire.

Selon un mode de réalisation, la section de coupe du contenant est circulaire.

Selon un mode de réalisation, le premier profil de base est un cercle ayant un premier rayon, et dans lequel le deuxième profil de base est un cercle ayant un deuxième rayon strictement inférieur au premier rayon, l'épaisseur de l'élément poreux étant égale à une différence entre le premier rayon et le deuxième rayon.

Selon un mode de réalisation, l'élément poreux présente une longueur, comptée longitudinalement le long de l'axe longitudinal, ladite longueur étant strictement supérieure à 80 cm, et notamment strictement supérieure à 2 m.

Selon un mode de réalisation, le dispositif de diffusion comprend :
- une première enceinte de réception délimitée par une première surface intérieure, et configurée pour recevoir un premier fluide précurseur ; et
- une deuxième enceinte de réception délimitée par une deuxième surface intérieure et configurée pour recevoir un deuxième fluide précurseur.

Il est bien compris que l'utilisation des termes « première » et « deuxième » n'est pas limitative et que selon le mode de réalisation, il peut y avoir au moins une enceinte de réception supplémentaire de même nature que les première et deuxième enceintes de réception et pour lequel les mêmes principes qu'elles s'appliquent. Autrement dit le contenant peut délimiter au moins trois enceintes de réception séparées, pouvant possiblement contenir respectivement des fluides précurseurs identiques ou différents d'une enceinte à l'autre.

Selon un mode de réalisation, le premier fluide précurseur est différent du deuxième fluide précurseur.

De cette manière, il est possible de générer deux types d'aérosols différents par l'intermédiaire d'un seul dispositif de diffusion. Par exemple, cela permet de diffuser localement, deux types de précurseurs différents, au niveau de la surface de croissance.

Selon un mode de réalisation, le premier fluide précurseur et le deuxième fluide précurseur sont identiques.

Selon un mode de réalisation, une première épaisseur comptée entre la première surface intérieure et la surface de diffusion de l'élément poreux, est strictement supérieure à une deuxième épaisseur comptée entre la deuxième surface intérieure et la surface de diffusion de l'élément poreux.

De cette manière, il est possible d'adapter l'épaisseur traversée par le fluide précurseur en fonction de l'enceinte de réception qui le contient et/ou de la nature de ce fluide précurseur. Ainsi, l'aérosol généré ou le diamètre des gouttelettes le constituant peut être différent.

Selon un mode de réalisation, le dispositif de diffusion comprend un organe de mise en pression associé à chaque enceinte de réception. Ainsi, il est possible d'adapter la pression à laquelle est placée le premier fluide précurseur et la pression à laquelle est placée le deuxième fluide précurseur en fonction de la nature du fluide précurseur utilisé.

Selon un mode de réalisation, le deuxième fluide précurseur comprend un liquide de refroidissement configuré pour refroidir l'élément poreux.

Selon un mode de réalisation, le dispositif de diffusion comprend un organe d'assemblage disposé au niveau d'une extrémité d'assemblage du dispositif de diffusion, ledit organe d'assemblage étant configuré pour permettre la fixation, au niveau de ladite extrémité d'assemblage, d'un élément externe choisi parmi : un autre dispositif de diffusion et l'organe de croissance.

Les dispositions précédemment décrites permettent d'assembler plusieurs dispositifs de diffusion les uns aux autres, afin de s'adapter à la forme de la surface de croissance.

Selon un mode de réalisation, l'extrémité d'assemblage est disposée au niveau de l'extrémité d'admission de fluide du contenant, vu suivant l'axe longitudinal.

Selon un mode de réalisation, l'élément poreux est obtenu par impression en trois dimensions (appelée communément impression 3D).

De manière avantageuse, la fabrication de l'élément poreux par impression 3D permet à la fois de définir simplement la forme de l'élément poreux même si cette forme est complexe, et également de diminuer les coûts de fabrication.

Par ailleurs, il est possible d'obtenir une forme spécifique de l'élément poreux, par exemple une forme intégrant une pluralité d'enceintes de réception permettant de stocker différents fluides précurseurs avant la mise en oeuvre d'une étape de mise en pression.

Par ailleurs, l'impression 3D permet simplement de prévoir au moins un organe d'assemblage au niveau de l'extrémité d'assemblage du dispositif de diffusion.

Selon un mode de réalisation, l'élément poreux est obtenu par un procédé de fusion de poudre.

Selon un mode de réalisation, le contenant est conformé de sorte à pouvoir être inséré dans une gaine tubulaire.

Selon un mode de réalisation, l'organe de croissance comprend la gaine tubulaire.

Selon un mode de réalisation, l'organe de croissance comprend au moins une bride configurée pour coopérer avec le dispositif de diffusion, par exemple au niveau de l'extrémité d'assemblage du dispositif de diffusion.

Le but de l'invention peut également être atteint grâce à la mise en oeuvre d'un procédé de dépôt d'une couche sur une surface de croissance, le procédé de dépôt comprenant :
- une étape de fourniture dans laquelle un dispositif de diffusion tel que décrit précédemment est fourni, l'au moins une enceinte de réception étant remplie au moins partiellement par un fluide précurseur ;
- une étape de mise à disposition d'un organe de croissance comprenant une surface de croissance ;
- une étape de positionnement, dans laquelle la surface de croissance est disposée en regard de la surface de diffusion du dispositif de diffusion ;
- une étape de mise en pression de l'enceinte de réception du dispositif de diffusion, dans laquelle le fluide précurseur est placé à une pression supérieure à la pression seuil, de manière à permettre le passage dudit fluide précurseur à travers l'épaisseur de l'élément poreux, de sorte à générer un aérosol par fragmentation du fluide précurseur lorsque le fluide précurseur traverse l'épaisseur de l'élément poreux, ledit aérosol étant alors formé de gouttelettes du fluide précurseur, et dirigé vers la surface de croissance ;
- une étape de croissance dans laquelle l'aérosol subit une réaction chimique au niveau de la surface de croissance pour former ladite couche.

Les dispositions précédemment décrites permettent de proposer un procédé de dépôt dans lequel un aérosol comprenant des gouttelettes d'un fluide précurseur est injecté localement au niveau d'une surface de croissance. De cette manière, il est possible de contrôler à la fois le type d'aérosol diffusé, et la quantité d'aérosol diffusé. Ainsi, les éventuelles pertes de fluide précurseur sont limitées.

Le procédé de dépôt peut en outre présenter une ou plusieurs des caractéristiques suivantes, prises seules ou en combinaison.

Selon un mode de réalisation, l'étape de positionnement est mise en oeuvre avant l'étape de mise en pression.

De cette manière, il est possible de positionner la surface externe de l'élément poreux en regard de la surface de croissance pour garantir une génération localisée de l'aérosol à proximité de la surface de croissance, de manière homogène sur la totalité de la surface de croissance.

Selon un mode de réalisation, le dispositif de diffusion est muni d'au moins un organe de mise en pression configuré pour mettre en oeuvre l'étape de mise en pression.

Selon un mode de réalisation, ledit au moins un organe de mise en pression est configuré pour injecter un gaz de mise en pression dans l'enceinte de réception.

Selon un mode de réalisation, au moins une étape choisie parmi l'étape de positionnement, l'étape de mise en pression et l'étape de croissance, est mise en oeuvre dans une chambre de croissance d'un four de croissance chimique, préférentiellement un four de dépôt chimique en phase vapeur.

De cette manière, l'étape de mise en pression permet d'apporter un agent précurseur contenu dans le fluide précurseur localement au niveau de la surface de croissance pour permettra la croissance d'une couche dans le four de dépôt chimique en phase vapeur lors de l'étape de croissance.

Selon un mode de réalisation, l'étape de croissance est mise en oeuvre dans le four de croissance chimique, de sorte que le four de croissance chimique place la chambre de croissance à une température de croissance pour chauffer l'organe de croissance et le dispositif de diffusion à ladite température de croissance pour favoriser la réaction chimique de l'aérosol au niveau de la surface de croissance.

Selon un mode de réalisation, la température de croissance est comprise entre 1000°C et 1500°C.

Selon un mode de réalisation, lors de l'étape de croissance, le four de croissance chimique place la chambre de croissance à une pression de croissance de manière à générer un vide de croissance permettant la croissance de la couche sur la surface de croissance.

Selon un mode de réalisation, la pression de croissance est inférieure à 10⁻⁶ Pa.

Selon un mode de réalisation, la chambre de croissance est placée sous atmosphère inerte lors de l'étape de croissance, ladite atmosphère inerte étant obtenue par l'injection d'un gaz inerte, par exemple l'argon ou l'azote.

Selon un mode de réalisation, le gaz de mise en pression utilisé durant l'étape de mise en pression est identique au gaz inerte utilisé pour placer la chambre de croissance sous atmosphère inerte.

Selon un mode de réalisation dans lequel l'élément poreux comprend une première enceinte de réception et une deuxième enceinte de réception, la deuxième enceinte de réception peut être configurée pour recevoir un fluide de refroidissement configuré pour refroidir l'élément poreux lors de l'étape de croissance. Ainsi, il est possible de refroidir l'élément poreux pour éviter un dépôt indésirable du fluide précurseur dans des pores de l'élément poreux, ce qui pourrait conduire à boucher lesdits pores de l'élément poreux et/ou à perturber une croissance homogène sur la surface de croissance.

Selon un mode de réalisation, l'étape de fourniture d'un dispositif de diffusion comprend une étape de fabrication de l'élément poreux par impression en trois dimensions.

De manière avantageuse, la fabrication de l'élément poreux par impression 3D permet à la fois de définir simplement la forme de l'élément poreux même suivant une forme complexe, et également de diminuer les coûts de fabrication.

Par ailleurs, il est possible d'obtenir une forme spécifique de l'élément poreux, par exemple une forme intégrant une pluralité d'enceintes de réception permettant de stocker différents fluides précurseurs avant la mise en oeuvre de l'étape de mise en pression.

Par ailleurs, l'impression 3D permet simplement de prévoir au moins un organe d'assemblage au niveau de l'extrémité d'assemblage du dispositif de diffusion.

Selon un mode de réalisation, l'élément poreux est obtenu par un procédé de fusion de poudre.

Selon un mode de réalisation, le procédé de dépôt comprend une étape de remplissage dans laquelle le fluide précurseur est introduit dans l'au moins une enceinte de réception du dispositif de diffusion.

Selon un mode de réalisation, l'étape de remplissage est mise en oeuvre avant l'étape de mise en pression.

Selon un mode de réalisation, l'étape de fourniture comprend la fourniture d'un dispositif de diffusion dans lequel le premier profil de base est un cercle ayant un premier rayon, et dans lequel le deuxième profil de base est un cercle ayant un deuxième rayon strictement inférieur au premier rayon, l'épaisseur de l'élément poreux étant égale à une différence entre le premier rayon et le deuxième rayon, et dans lequel l'étape de mise à disposition d'un organe de croissance comprend la mise à disposition d'un organe de croissance globalement tubulaire le long d'un axe principal, ledit organe de croissance délimitant intérieurement une cavité ouverte vers l'extérieur au niveau d'une ouverture d'insertion disposée à une extrémité de l'organe de croissance considérée suivant l'axe principal, ladite cavité délimitant au moins ladite surface de croissance et se présentant sous la forme d'une troisième forme prismatique caractérisée par un troisième profil de base, ladite troisième forme prismatique étant générée par la translation rectiligne dudit troisième profil de base le long de l'axe principal, ledit troisième profil de base étant un cercle ayant un rayon strictement supérieur au premier rayon, l'étape de positionnement comprenant une étape d'insertion du dispositif de diffusion à l'intérieur de la cavité de l'organe de croissance au travers de l'ouverture d'insertion suivant l'axe principal.

Selon un mode de réalisation, l'axe principal est parallèle ou confondu avec l'axe longitudinal.

Selon un mode de réalisation, une longueur de l'élément poreux comptée le long de l'axe longitudinal du contenant est strictement supérieure à une longueur de l'organe de croissance comptée le long de l'axe principal, de sorte qu'après l'étape d'insertion du dispositif de diffusion à l'intérieur de l'organe de croissance, l'intégralité de la surface de croissance est en regard d'au moins une partie de la surface externe de l'élément poreux.

De cette manière, la génération de l'aérosol est uniforme sur toute la longueur de l'organe de croissance et sur toute la surface de la surface de croissance.

Enfin, le but de l'invention peut également être atteint grâce à la mise en oeuvre d'un système comprenant un dispositif de diffusion du type d'un de ceux décrits précédemment, et un organe de croissance.

### Description sommaire des dessins

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :
[Fig. 1] La figure 1 est une vue schématique en coupe d'un dispositif de diffusion d'un précurseur selon un premier mode de réalisation de l'invention.
[Fig. 2] La figure 2 est une vue schématique en coupe d'un dispositif de diffusion d'un précurseur selon un deuxième mode de réalisation de l'invention.
[Fig. 3] La figure 3 est une vue schématique en perspective de deux dispositif de diffusion d'un précurseur selon un mode de réalisation de l'invention.
[Fig. 4] La figure 4 est une vue schématique en coupe d'un dispositif de diffusion d'un précurseur selon le mode de réalisation de la figure 1 et d'un organe de croissance.
[Fig. 5] La figure 5 est une vue schématique de certaines étapes du procédé de dépôt selon un mode de réalisation particulier de l'invention.
[Fig. 6] La figure 6 est une vue schématique de certaines étapes du procédé de dépôt selon un mode de réalisation particulier de l'invention.

### Description détaillée

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

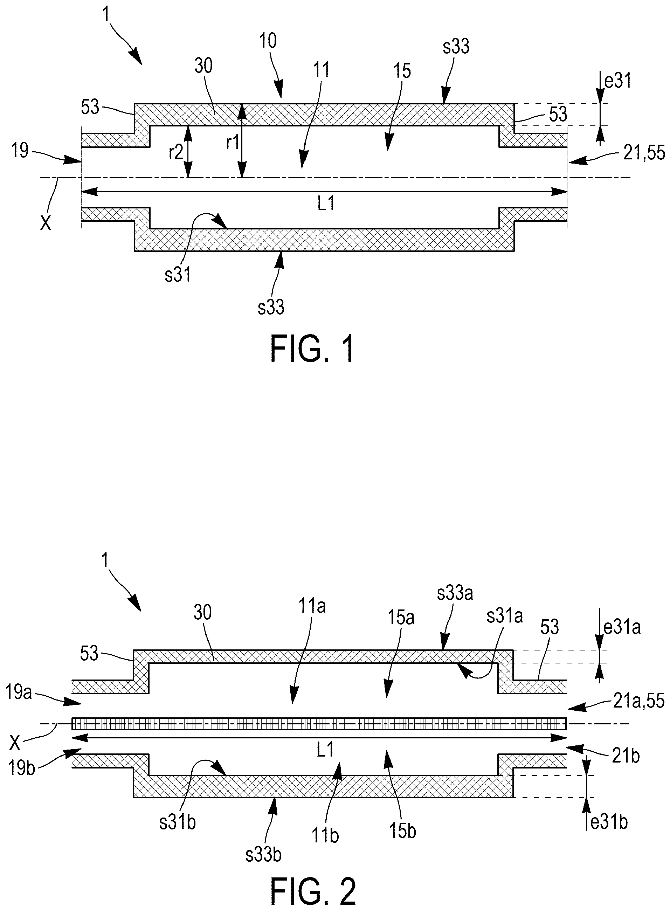

Comme cela est illustré sur les figures 1 à 6, l'invention concerne un dispositif de diffusion 1 d'un précurseur, configuré pour diffuser un précurseur de croissance vers une surface de croissance s101. Ladite surface de croissance est incluse sur un organe de croissance 100 externe, pouvant par exemple comprendre une gaine tubulaire 101. Un tel organe de croissance 100 peut avantageusement être utilisé pour accueillir une pastille de combustible. L'invention concerne également un procédé de dépôt d'une couche 103 sur ladite surface de croissance s101. De manière avantageuse, il peut donc être prévu qu'un tel procédé de dépôt soit utilisé pour déposer une couche 103 de protection sur une gaine accueillant une pastille de combustible, afin de limiter voire supprimer les effets de l'IPG. Comme cela sera décrit plus en détail ci-après en référence au procédé de dépôt, le dispositif de diffusion 1 est adapté pour être utilisé dans un procédé de dépôt chimique en phase vapeur. Par conséquent, le dispositif de diffusion 1 est adapté pour rester intègre à des températures comprises entre 1000°C et 1500°C, et/ou à des pressions basses, typiquement inférieures à 10⁻⁶ Pa.

En référence aux figures 1 et 2, le dispositif de diffusion 1 comprend un contenant 10 délimitant intérieurement au moins une enceinte de réception 11. Le contenant 10 est au moins en partie constitué par au moins un élément poreux 30 qui délimite intérieurement une surface intérieure s31, et qui délimite extérieurement une surface de diffusion s33 destinée à être tournée vers la surface de croissance s101 externe. La surface intérieure s31 délimite alors au moins partiellement l'au moins une enceinte de réception 11.

De manière avantageuse, l'élément poreux 30 est essentiellement constitué ou comprend un matériau métallique. Le matériau métallique de l'élément poreux 30 comprend au moins l'un des matériaux suivants sous forme pure, d'alliage ou d'oxyde : aluminium, acier inoxydable, nickel, ou tungstène.

Selon les variantes non limitatives représentées sur les figures 1 et 2, le contenant 10 s'étend globalement le long d'un axe longitudinal X et comprend une extrémité obturée 19 et une extrémité d'admission de fluide 21 distantes l'une de l'autre le long de l'axe longitudinal X. L'élément poreux 30 est situé entre ces deux extrémités et l'enceinte de réception 11 peut être fermée au niveau de l'extrémité obturée 19. Selon ces variantes, le contenant 10 est intégralement formé par l'élément poreux 30. L'élément poreux 30 peut par exemple présenter une longueur L1, comptée longitudinalement le long de l'axe longitudinal X qui est strictement supérieure à 80 cm, et notamment strictement supérieure à 2 m. Par ailleurs, la surface de diffusion s33 de l'élément poreux 30 peut présenter une première forme prismatique caractérisée par un premier profil de base, ladite première forme prismatique étant générée par la translation rectiligne dudit premier profil de base le long de l'axe longitudinal X. La surface intérieure s31 de l'élément poreux 30 présente une deuxième forme prismatique caractérisée par un deuxième profil de base, ladite deuxième forme prismatique étant générée par la translation rectiligne dudit deuxième profil de base le long de l'axe longitudinal X. Plus particulièrement, au moins une surface choisie parmi la surface de diffusion s33 et la surface intérieure s31 de l'élément poreux 30 se présente sous la forme de tout ou partie d'une surface cylindrique. La figure 1 présente notamment une variante où la surface de diffusion s33 et la surface intérieure s31 présentent la forme d'une surface cylindrique. Par « surface cylindrique » on entend mathématiquement une surface en trois dimensions engendrée par une droite génératrice qui se déplace selon une direction donnée en s'appuyant sur une ligne courbe fermée appelée directrice. Dans le cas présent, la directrice correspond au profil de la section de coupe du contenant 10 au niveau de l'élément poreux 30 tandis que la droite génératrice est orientée de manière parallèle à l'axe longitudinal X. Selon les modes de réalisation, la section de coupe du contenant 10 est circulaire, afin que le contenant 10 soit conformé de sorte à pouvoir être inséré dans une gaine tubulaire 101. Il est donc bien compris que selon la variante illustrée sur la figure 1, la surface de diffusion s33 est tubulaire, et la surface intérieure s31 est tubulaire. En d'autres termes, le premier profil de base est un cercle ayant un premier rayon r1, le deuxième profil de base est un cercle ayant un deuxième rayon r2 strictement inférieur au premier rayon r1.

Ladite au moins une enceinte de réception 11 du dispositif de diffusion 1 est configurée pour contenir un fluide précurseur 15 comprenant le précurseur de croissance. De manière générale, l'enceinte de réception 11 est configurée pour recevoir le fluide précurseur 15 au niveau de l'extrémité d'admission de fluide 21. Le dispositif de diffusion 1 comprend donc le fluide précurseur 15 contenu dans l'enceinte de réception 11. Selon un premier mode de réalisation, le fluide précurseur 15 est liquide, par exemple, le fluide précurseur 15 peut comprendre un agent précurseur solide dissout dans un solvant. Alternativement, le fluide précurseur 15 peut comprendre un mélange d'un solvant et d'un agent précurseur liquide. Selon un mode de réalisation, l'agent précurseur comprend l'oxyde de chrome Cr₂O₃. Dans la variante non limitative représentée sur la figure 2, le dispositif de diffusion 1 comprend une première enceinte de réception 11a délimitée par une première surface intérieure s31a, et configurée pour recevoir un premierfluide précurseur 15a, et une deuxième enceinte de réception 11b délimitée par une deuxième surface intérieure s31b et configurée pour recevoir un deuxième fluide précurseur 15b. Il est bien compris que l'utilisation des termes « première » et « deuxième » n'est pas limitative et que selon le mode de réalisation, il peut y avoir au moins une enceinte de réception 11 supplémentaire de même nature que les première et deuxième enceintes de réception 11a, 11b et pour lequel les mêmes principes qu'elles s'appliquent. Autrement dit le contenant 10 peut délimiter au moins trois enceintes de réception 11 séparées, pouvant possiblement contenir respectivement des fluides précurseurs 15 identiques ou différents d'une enceinte à l'autre. Ainsi, le premier fluide précurseur 15a peut être différent du deuxième fluide précurseur 15b. De cette manière, il est possible de générer deux types d'aérosols différents par l'intermédiaire d'un seul dispositif de diffusion 1. Par exemple, cela permet de diffuser localement alternativement ou simultanément, deux types de précurseurs différents, au niveau de la surface de croissance s101. Par exemple, le deuxième fluide précurseur 15b peut comprendre un liquide de refroidissement configuré pour refroidir l'élément poreux 30. Alternativement, il peut être prévu que, le premier fluide précurseur 15a et le deuxième fluide précurseur 15b soient identiques.

L'élément poreux 30 présente une porosité configurée d'une part pour permettre audit fluide précurseur 15 de traverser une épaisseur e31 de l'élément poreux 30 comptée entre ladite surface intérieure s31 et ladite surface de diffusion s33 tant qu'une pression du fluide précurseur 15 contenu dans l'enceinte de réception 11 est strictement supérieure à une pression seuil, et d'autre part pour empêcher au fluide précurseur 15 de traverser ladite épaisseur e31 de l'élément poreux 30 lorsque la pression du fluide précurseur 15 contenu dans l'enceinte de réception 11 est inférieure à ladite pression seuil. Par exemple, l'élément poreux 30 peut comprendre des pores ayant un diamètre moyen compris entre 2µm et 100µm. La pression seuil est strictement supérieure à une pression externe régnant à l'extérieur du contenant 10. Par exemple, la pression seuil est comprise entre 2.10⁵ Pa et 20.10⁵ Pa. L'élément poreux 30 est en outre configuré de sorte que le fluide précurseur 15 qui traverse l'épaisseur e31 de l'élément poreux 30 génère, à partir de la surface de diffusion s33, un aérosol 17 par fragmentation du fluide précurseur 15. Ledit aérosol 17 est formé de gouttelettes du fluide précurseur 15 et est contenu entre la surface de diffusion s33 et la surface de croissance s101 externe. Selon la variante illustrée sur la figure 1, l'épaisseur e31 de l'élément poreux 30 est égale à une différence entre le premier rayon r1 et le deuxième rayon r2. Selon la variante illustrée sur la figure 2 une première épaisseur e31a est comptée entre la première surface intérieure s31a et la surface de diffusion s33 de l'élément poreux 30, et une deuxième épaisseur e31b est comptée entre la deuxième surface intérieure s31b et la surface de diffusion s33 de l'élément poreux 30. La première épaisseur e31a est strictement supérieure à la deuxième épaisseur e31b. De cette manière, il est possible d'adapter l'épaisseur e31 traversée par le fluide précurseur 15 en fonction de l'enceinte de réception 11a, 11b qui le contient et/ou de la nature de ce fluide précurseur 15. Ainsi, l'aérosol 17 généré ou le diamètre des gouttelettes le constituant peut être différent.

De manière générale, le dispositif de diffusion 1 est configuré pour apporter un aérosol 17 comprenant au moins un agent précurseur au niveau de la surface de croissance s101 d'une manière permettant la croissance d'une couche 103 sur la surface de croissance s101. Par exemple, ladite couche 103 peut être une couche 103 de protection. Avantageusement, le dispositif de diffusion 1 permet de contrôler l'épaisseur de la couche 103 de protection déposée sur la surface de croissance s101.

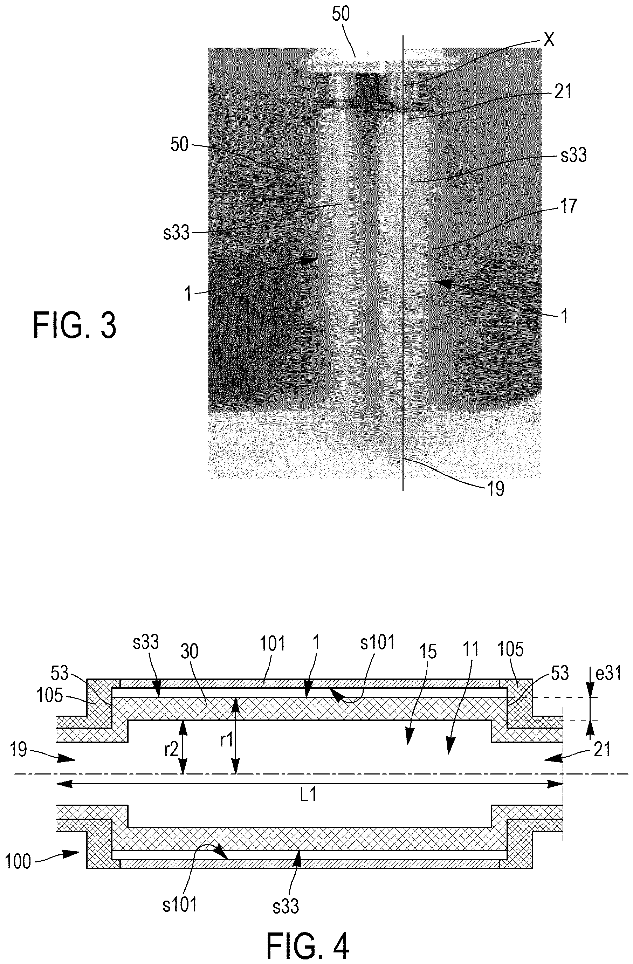

La figure 3 illustre la formation dudit aérosol 17 par deux dispositifs de diffusion 1 distincts. Comme cela est illustré sur la figure 3, le dispositif de diffusion 1 peut comprendre au moins un organe de mise en pression 50 configuré pour faire varier la pression du fluide précurseur 15 à l'intérieur de l'enceinte de réception 11, de manière à placer le fluide précurseur 15 à une pression supérieure à la pression seuil, pour permettre au fluide précurseur 15 de traverser l'élément poreux 30, de la surface intérieure s31 vers la surface de diffusion s33. Par exemple l'organe de mise en pression 50 comprend une pompe pneumatique. L'au moins un organe de mise en pression 50 peut être disposé au niveau de l'extrémité d'admission de fluide 21 de l'élément poreux 30. Dans le cas non limitatif où le dispositif de diffusion 1 comprend deux enceintes de réceptions 11a, 11b il peut être prévu que le dispositif de diffusion 1 comprenne un organe de mise en pression 50 associé à chaque enceinte de réception 11a, 11b. Ainsi, il est possible d'adapter la pression à laquelle est placée le premier fluide précurseur 15a et la pression à laquelle est placée le deuxième fluide précurseur 15b en fonction de la nature du fluide précurseur 15a, 15b utilisé.

Enfin, et en référence notamment à la figure 4, le dispositif de diffusion 1 peut comprendre un organe d'assemblage 53 disposé au niveau d'une extrémité d'assemblage 55 du dispositif de diffusion 1. Par exemple, l'extrémité d'assemblage 55 est disposée au niveau de l'extrémité d'admission de fluide 21 du contenant 10, vu suivant l'axe longitudinal X. L'organe d'assemblage 53 est configuré pour permettre la fixation, au niveau de ladite extrémité d'assemblage 55, d'un élément externe choisi parmi : un autre dispositif de diffusion et l'organe de croissance 100. Les dispositions précédemment décrites permettent d'assembler plusieurs dispositifs de diffusion les uns aux autres, afin de s'adapter à la forme de la surface de croissance s101. Cependant, et comme cela est illustré sur la figure 4 ledit organe d'assemblage 53 est configuré pour permettre la fixation de l'organe de croissance 100. Selon cette variante, le dispositif de diffusion comprend deux organes d'assemblages 53 venus de matière avec l'élément poreux. Ces organes d'assemblages 53 se présentent sous la forme d'épaulements annulaires disposés autour de l'axe longitudinal X. Dans ce cas, il peut être prévu que, l'organe de croissance 100 comprenne au moins une bride 105 configurée pour coopérer avec le dispositif de diffusion 1, par exemple au niveau de l'extrémité d'assemblage 55 du dispositif de diffusion 1. La figure 4 illustre donc une variante non limitative dans laquelle deux brides 105 coopèrent avec les organes d'assemblage 53 du dispositif de diffusion 1.

De manière avantageuse, il peut être prévu que l'élément poreux 30 soit obtenu par impression en trois dimensions. En effet, la fabrication de l'élément poreux 30 par impression 3D permet à la fois de définir simplement la forme de l'élément poreux 30 même si cette forme est complexe, et également de diminuer les coûts de fabrication. Par ailleurs, il est possible d'obtenir une forme spécifique de l'élément poreux 30, par exemple une forme intégrant une pluralité d'enceintes de réception 11a, 11b permettant de stocker différents fluides précurseurs 15a, 15b avant la mise en oeuvre d'une étape de mise en pression. En outre, l'impression 3D permet simplement de prévoir au moins un organe d'assemblage 53 au niveau de l'extrémité d'assemblage 55 du dispositif de diffusion 1.

Alternativement, l'élément poreux 30 peut être obtenu par un procédé de fusion de poudre.

Les dispositions précédemment décrites permettent de proposer un dispositif de diffusion 1 apte à générer un aérosol 17 comprenant des gouttelettes d'un fluide précurseur 15 au niveau d'une surface de croissance s101. De manière avantageuse, le dispositif de diffusion 1 précédemment décrit permet de contrôler à la fois le type de fluide précurseur 15 compris dans l'aérosol 17 diffusé, et la quantité d'aérosol 17 diffusé. Par ailleurs, il est possible de diffuser ledit aérosol 17 localement à proximité de la surface de croissance s101. Ainsi, les éventuelles pertes de fluide précurseur 15 sont limitées. Enfin, le dispositif de diffusion 1 permet de diffuser le fluide précurseur 15 sous forme de liquide ultra divisé ou gazeux de façon homogène sur toute la surface de croissance s101, évitant les inhomogénéités. La fragmentation du fluide précurseur 15 permet d'améliorer son évaporation et sa réactivité, en particulier lorsqu'il est utilisé dans un procédé de dépôt chimique en phase vapeur dans un four de croissance chimique.

Comme indiqué précédemment, l'invention concerne également un procédé de dépôt d'une couche 103 sur une surface de croissance s101 d'un organe de croissance 100.

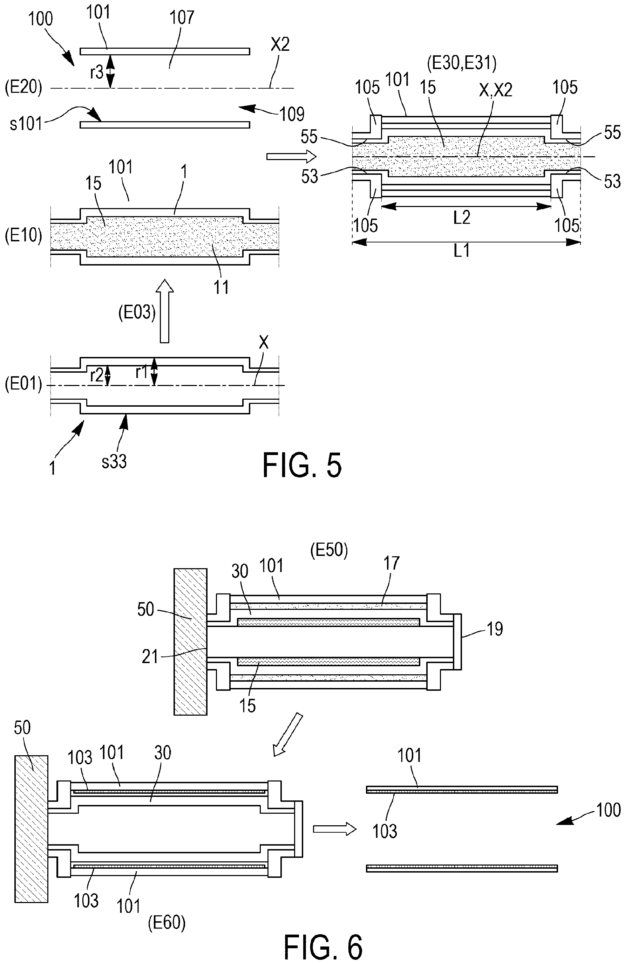

Le procédé de dépôt illustré par exemple sur les figures 5 et 6 comprend tout d'abord une étape de fourniture E10 dans laquelle un dispositif de diffusion 1 tel que décrit précédemment est fourni. L'étape de fourniture E10 d'un dispositif de diffusion 1 peut comprendre une étape de fabrication E01 de l'élément poreux 30 par impression en trois dimensions. Alternativement, l'élément poreux 30 peut être obtenu par un procédé de fusion de poudre. De manière avantageuse, la fabrication de l'élément poreux 30 par impression 3D permet à la fois de définir simplement la forme de l'élément poreux 30 même suivant une forme complexe, et également de diminuer les coûts de fabrication. Par ailleurs, l'impression 3D permet simplement de prévoir au moins un organe d'assemblage 53 au niveau de l'extrémité d'assemblage 55 du dispositif de diffusion 1 permettant la mise en oeuvre plus aisée d'une étape de positionnement E30 qui sera décrite ci-après. Enfin, l'impression 3D permet d'obtenir une forme spécifique de l'élément poreux 30, par exemple une forme intégrant une pluralité d'enceintes de réception 11a, 11b permettant de stocker différents fluides précurseurs 15a, 15b avant la mise en oeuvre d'une étape de mise en pression E50 qui sera décrite plus loin.

Ensuite, il peut être prévu que le procédé de dépôt comprenne une étape de remplissage E03 dans laquelle le fluide précurseur 15 est introduit dans l'au moins une enceinte de réception 11 du dispositif de diffusion 1. Cette étape de remplissage E03 est mise en oeuvre avant l'étape de mise en pression E50. De cette manière, l'au moins une enceinte de réception 11 est remplie au moins partiellement par un fluide précurseur 15 lors de l'étape de fourniture E10.

Le procédé de dépôt comprend également une étape de mise à disposition E20 d'un organe de croissance 100 comprenant une surface de croissance s101. Selon la variante non limitative illustrée sur la figure 5, l'organe de croissance 100 est globalement tubulaire le long d'un axe principal X2, et délimite intérieurement une cavité 107 ouverte vers l'extérieur au niveau d'une ouverture d'insertion 109 disposée à une extrémité de l'organe de croissance 100 considérée suivant l'axe principal X2. Cette cavité 107 délimite au moins partiellement ladite surface de croissance s101.

Ensuite, le procédé de dépôt comprend une étape de positionnement E30, dans laquelle la surface de croissance s101 est disposée en regard de la surface de diffusion s33 du dispositif de diffusion 1. Comme cela est illustré sur la figure 5, l'étape de fourniture E10 peut comprendre la fourniture d'un dispositif de diffusion 1 dans lequel le premier profil de base est un cercle ayant un premier rayon r1, et dans lequel le deuxième profil de base est un cercle ayant un deuxième rayon r2 strictement inférieur au premier rayon r1, l'épaisseur e31 de l'élément poreux 30 étant égale à une différence entre le premier rayon r1 et le deuxième rayon r2. L'étape de mise à disposition E20 d'un organe de croissance 100 peut comprendre la mise à disposition d'un organe de croissance 100 dans laquelle la surface de croissance s101 se présentant sous la forme d'une troisième forme prismatique caractérisée par un troisième profil de base, ladite troisième forme prismatique étant générée par la translation rectiligne dudit troisième profil de base le long de l'axe principal X2, ledit troisième profil de base étant un cercle ayant un rayon r3 strictement supérieur au premier rayon r1. Ainsi, l'étape de positionnement E30 peut comprendre une étape d'insertion E31 du dispositif de diffusion 1 à l'intérieur de la cavité 107 de l'organe de croissance 100 au travers de l'ouverture d'insertion 109 suivant l'axe principal X2. L'axe principal X2 est alors parallèle ou confondu avec l'axe longitudinal X. De manière avantageuse, il peut être prévu qu'une longueur L1 de l'élément poreux 30 comptée le long de l'axe longitudinal X du contenant 10 soit strictement supérieure à une longueur L2 de l'organe de croissance 100 comptée le long de l'axe principal X2, de sorte qu'après l'étape d'insertion E31 du dispositif de diffusion 1 à l'intérieur de l'organe de croissance 100, l'intégralité de la surface de croissance s101 soit en regard d'au moins une partie de la surface externe de l'élément poreux 30. De cette manière, la génération de l'aérosol 17 est uniforme sur toute la longueur L1 de l'organe de croissance 100 et sur toute la surface de la surface de croissance s101.

Le procédé de dépôt comprend en outre une étape de mise en pression E50 de l'enceinte de réception 11 du dispositif de diffusion 1 généralement mise en oeuvre après l'étape de positionnement E30. De cette manière, il est possible de positionner la surface externe de l'élément poreux 30 en regard de la surface de croissance s101 pour garantir une génération localisée de l'aérosol 17 à proximité de la surface de croissance s101, de manière homogène sur la totalité de la surface de croissance s101. Lors de cette étape de mise en pression E50, le fluide précurseur 15 est placé à une pression supérieure à la pression seuil, de manière à permettre le passage dudit fluide précurseur 15 à travers l'épaisseur e31 de l'élément poreux 30, de sorte à générer l'aérosol 17 par fragmentation du fluide précurseur 15 lorsque le fluide précurseur 15 traverse l'épaisseur e31 de l'élément poreux 30, ledit aérosol 17 étant alors formé de gouttelettes du fluide précurseur 15, et dirigé vers la surface de croissance s101. Selon le mode de réalisation représenté sur la figure 6, le dispositif de diffusion 1 est muni d'au moins un organe de mise en pression 50 configuré pour mettre en oeuvre l'étape de mise en pression E50. Par exemple, l'organe de mise en pression 50 est configuré pour injecter un gaz de mise en pression dans l'enceinte de réception 11.

Enfin, le procédé de dépôt comprend une étape de croissance E60 dans laquelle l'aérosol 17 subit une réaction chimique au niveau de la surface de croissance s101 pour former ladite couche 103. Pour cela, l'étape de croissance E60 peut être mise en oeuvre dans le four de croissance chimique, de sorte que le four de croissance chimique place la chambre de croissance à une température de croissance pour chauffer l'organe de croissance 100 et le dispositif de diffusion 1 à ladite température de croissance pour favoriser la réaction chimique de l'aérosol 17 au niveau de la surface de croissance s101. Par exemple, la température de croissance est comprise entre 1000°C et 1500°C. Par ailleurs, lors de cette étape de croissance E60, le four de croissance chimique peut placer la chambre de croissance à une pression de croissance de manière à générer un vide de croissance permettant la croissance de la couche 103 sur la surface de croissance s101. Par exemple, la pression de croissance est inférieure à 10⁻⁶ Pa. Enfin, la chambre de croissance peut être placée sous atmosphère inerte lors de l'étape de croissance E60, ladite atmosphère inerte étant obtenue par l'injection d'un gaz inerte, par exemple l'argon ou l'azote. De manière avantageuse, le gaz de mise en pression utilisé durant l'étape de mise en pression E50 est identique au gaz inerte utilisé pour placer la chambre de croissance sous atmosphère inerte.

De manière générale, au moins une étape choisie parmi l'étape de positionnement E30, l'étape de mise en pression E50 et l'étape de croissance E60, est mise en oeuvre dans la chambre de croissance du four de croissance chimique, préférentiellement un four de dépôt chimique en phase vapeur. De cette manière, l'étape de mise en pression E50 permet d'apporter un agent précurseur contenu dans le fluide précurseur 15 localement au niveau de la surface de croissance s101 pour permettra la croissance d'une couche 103 dans le four de dépôt chimique en phase vapeur lors de l'étape de croissance E60.

Dans le cas où l'élément poreux 30 comprend une première enceinte de réception 11a et une deuxième enceinte de réception 11b, la deuxième enceinte de réception 11b peut être configurée pour recevoir un fluide de refroidissement configuré pour refroidir l'élément poreux 30 lors de l'étape de croissance E60. Ainsi, il est possible de refroidir l'élément poreux 30 pour éviter un dépôt indésirable du fluide précurseur 15 dans des pores de l'élément poreux 30, ce qui pourrait conduire à boucher lesdits pores de l'élément poreux 30 et/ou à perturber une croissance homogène sur la surface de croissance s101.

Les dispositions précédemment décrites permettent de proposer un procédé de dépôt dans lequel un aérosol 17 comprenant des gouttelettes d'un fluide précurseur 15 est injecté localement au niveau d'une surface de croissance s101. De cette manière, il est possible de contrôler à la fois le type d'aérosol 17 diffusé, et la quantité d'aérosol 17 diffusé. Ainsi, les éventuelles pertes de fluide précurseur 15 sont limitées.

## Revendications

1. Dispositif de diffusion (1) d'un précurseur configuré pour diffuser un précurseur de croissance vers une surface de croissance (s101) externe comprise sur un organe de croissance (100) externe, ledit dispositif de diffusion (1) comprenant un contenant (10) délimitant intérieurement au moins une enceinte de réception (11), le contenant (10) étant au moins en partie constitué par au moins un élément poreux (30), ledit élément poreux (30) délimitant intérieurement une surface intérieure (s31), ladite surface intérieure (s31) délimitant au moins partiellement l'au moins une enceinte de réception (11), ledit élément poreux (30) délimitant extérieurement une surface de diffusion (s33) destinée à être tournée vers la surface de croissance (s101) externe, ladite au moins une enceinte de réception (11) étant configurée pour contenir un fluide précurseur (15) comprenant ledit précurseur de croissance,
le dispositif de diffusion (1) comprenant le fluide précurseur (15) contenu dans l'enceinte de réception (11),
ledit élément poreux (30) présentant une porosité configurée d'une part pour permettre audit fluide précurseur (15) de traverser une épaisseur (e31) de l'élément poreux (30) comptée entre ladite surface intérieure (s31) et ladite surface de diffusion (s33) tant qu'une pression du fluide précurseur (15) contenu dans l'enceinte de réception (11) est strictement supérieure à une pression seuil, d'autre part pour empêcher au fluide précurseur (15) de traverser ladite épaisseur (e31) de l'élément poreux (30) lorsque la pression du fluide précurseur (15) contenu dans l'enceinte de réception (11) est inférieure à ladite pression seuil, ladite pression seuil étant strictement supérieure à une pression externe régnant à l'extérieur du contenant (10);
l'élément poreux (30) étant configuré de sorte que le fluide précurseur (15) qui traverse l'épaisseur (e31) de l'élément poreux (30) génère, à partir de la surface de diffusion (s33), un aérosol (17) par fragmentation du fluide précurseur (15),
ledit aérosol (17) étant formé de gouttelettes du fluide précurseur (15) et contenu entre la surface de diffusion (s33) et la surface de croissance (s101) externe.

2. Dispositif de diffusion (1) selon la revendication 1, dans lequel le contenant (10) est intégralement formé par l'élément poreux (30).

3. Dispositif de diffusion (1) selon l'une quelconque des revendications 1 ou 2, comprenant au moins un organe de mise en pression (50) configuré pour faire varier la pression du fluide précurseur (15) à l'intérieur de l'enceinte de réception (11), de manière à placer le fluide précurseur (15) à une pression supérieure à la pression seuil, pour permettre au fluide précurseur (15) de traverser l'élément poreux (30), de la surface intérieure (s31) vers la surface de diffusion (s33).

4. Dispositif de diffusion (1) selon l'une quelconque des revendications 1 à 3, dans lequel le contenant (10) s'étend globalement le long d'un axe longitudinal (X) et comprend une extrémité obturée (19) et une extrémité d'admission de fluide (21) distantes l'une de l'autre le long de l'axe longitudinal (X), l'élément poreux (30) étant situé entre ces deux extrémités et l'enceinte de réception (11) étant configurée pour recevoir le fluide précurseur (15) au niveau de l'extrémité d'admission de fluide (21) et être fermée au niveau de l'extrémité obturée (19).

5. Dispositif de diffusion (1) selon la revendication 4, dans lequel la surface de diffusion (s33) de l'élément poreux (30) présente une première forme prismatique **caractérisée par** un premier profil de base, ladite première forme prismatique étant générée par la translation rectiligne dudit premier profil de base le long de l'axe longitudinal (X), et dans lequel la surface intérieure (s31) de l'élément poreux (30) présente une deuxième forme prismatique **caractérisée par** un deuxième profil de base, ladite deuxième forme prismatique étant générée par la translation rectiligne dudit deuxième profil de base le long de l'axe longitudinal (X).

6. Dispositif de diffusion (1) selon la revendication 5, dans lequel le premier profil de base est un cercle ayant un premier rayon (r1), et dans lequel le deuxième profil de base est un cercle ayant un deuxième rayon (r2) strictement inférieur au premier rayon (r1), l'épaisseur (e31) de l'élément poreux (30) étant égale à une différence entre le premier rayon (r1) et le deuxième rayon (r2).

7. Dispositif de diffusion (1) selon l'une quelconque des revendications 4 à 6, dans lequel l'élément poreux (30) présente une longueur (L1), comptée longitudinalement le long de l'axe longitudinal (X), ladite longueur (L1) étant strictement supérieure à 80 cm, et notamment strictement supérieure à 2 m.

8. Dispositif de diffusion (1) selon l'une quelconque des revendications 1 à 7, comprenant :
- une première enceinte de réception (11a) délimitée par une première surface intérieure (s31a), et configurée pour recevoir un premier fluide précurseur (15a) ; et
- une deuxième enceinte de réception (11b) délimitée par une deuxième surface intérieure (s31b) et configurée pour recevoir un deuxième fluide précurseur (15b).

9. Dispositif de diffusion (1) selon l'une quelconque des revendications 1 à 8, comprenant un organe d'assemblage (53) disposé au niveau d'une extrémité d'assemblage (55) du dispositif de diffusion (1), ledit organe d'assemblage (53) étant configuré pour permettre la fixation, au niveau de ladite extrémité d'assemblage (55), d'un élément externe choisi parmi : un autre dispositif de diffusion et l'organe de croissance (100).

10. Dispositif de diffusion (1) selon l'une quelconque des revendications 1 à 9, dans lequel l'élément poreux (30) est obtenu par impression en trois dimensions.

11. Dispositif de diffusion (1) selon l'une quelconque des revendication 1 à 10, dans lequel le contenant (10) est conformé de sorte à pouvoir être inséré dans une gaine tubulaire (101).

12. Procédé de dépôt d'une couche (103) sur une surface de croissance (s101), le procédé de dépôt comprenant :
- une étape de fourniture (E10) dans laquelle un dispositif de diffusion (1) selon l'une quelconque des revendications 1 à 11 est fourni, l'au moins une enceinte de réception (11) étant remplie au moins partiellement par un fluide précurseur (15) ;
- une étape de mise à disposition (E20) d'un organe de croissance (100) comprenant une surface de croissance (s101) ;
- une étape de positionnement (E30), dans laquelle la surface de croissance (s101) est disposée en regard de la surface de diffusion (s33) du dispositif de diffusion (1) ;
- une étape de mise en pression (E50) de l'enceinte de réception (11) du dispositif de diffusion (1), dans laquelle le fluide précurseur (15) est placé à une pression supérieure à la pression seuil, de manière à permettre le passage dudit fluide précurseur (15) à travers l'épaisseur (e31) de l'élément poreux (30), de sorte à générer un aérosol (17) par fragmentation du fluide précurseur (15) lorsque le fluide précurseur (15) traverse l'épaisseur (e31) de l'élément poreux (30), ledit aérosol (17) étant alors formé de gouttelettes du fluide précurseur (15), et dirigé vers la surface de croissance (s101) ;
- une étape de croissance (E60) dans laquelle l'aérosol (17) subit une réaction chimique au niveau de la surface de croissance (s101) pour former ladite couche (103).

13. Procédé de dépôt selon la revendication 12, dans lequel l'étape de positionnement (E30) est mise en oeuvre avant l'étape de mise en pression (E50).

14. Procédé de dépôt selon l'une quelconque des revendications 12 ou 13, dans lequel au moins une étape choisie parmi l'étape de positionnement (E30), l'étape de mise en pression (E50) et l'étape de croissance (E60), est mise en oeuvre dans une chambre de croissance d'un four de croissance chimique, préférentiellement un four de dépôt chimique en phase vapeur.

15. Procédé de dépôt selon la revendication 14, dans lequel l'étape de croissance (E60) est mise en oeuvre dans le four de croissance chimique, de sorte que le four de croissance chimique place la chambre de croissance à une température de croissance pour chauffer l'organe de croissance (100) et le dispositif de diffusion (1) à ladite température de croissance pour favoriser la réaction chimique de l'aérosol (17) au niveau de la surface de croissance (s101).

16. Procédé de dépôt selon l'une quelconque des revendications 12 à 15, dans lequel l'étape de fourniture (E10) d'un dispositif de diffusion (1) comprend une étape de fabrication (E01) de l'élément poreux (30) par impression en trois dimensions.

17. Procédé de dépôt selon l'une quelconque des revendications 12 à 16, comprenant une étape de remplissage (E03) dans laquelle le fluide précurseur (15) est introduit dans l'au moins une enceinte de réception (11) du dispositif de diffusion (1).

18. Procédé de dépôt selon l'une quelconque des revendications 12 à 17, dans lequel l'étape de fourniture (E10) comprend la fourniture d'un dispositif de diffusion (1) selon la revendication 6, et dans lequel l'étape de mise à disposition (E20) d'un organe de croissance (100) comprend la mise à disposition d'un organe de croissance (100) globalement tubulaire le long d'un axe principal (X2), ledit organe de croissance (100) délimitant intérieurement une cavité (107) ouverte vers l'extérieur au niveau d'une ouverture d'insertion (109) disposée à une extrémité de l'organe de croissance (100) considérée suivant l'axe principal (X2), ladite cavité (107) délimitant au moins ladite surface de croissance (s101) et se présentant sous la forme d'une troisième forme prismatique **caractérisée par** un troisième profil de base, ladite troisième forme prismatique étant générée par la translation rectiligne dudit troisième profil de base le long de l'axe principal (X2), ledit troisième profil de base étant un cercle ayant un rayon (r3) strictement supérieur au premier rayon (r1),
l'étape de positionnement (E30) comprenant une étape d'insertion (E31) du dispositif de diffusion (1) à l'intérieur de la cavité (107) de l'organe de croissance (100) au travers de l'ouverture d'insertion (109) suivant l'axe principal (X2).

19. Procédé de dépôt selon la revendication 18, dans lequel une longueur (L1) de l'élément poreux (30) comptée le long de l'axe longitudinal (X) du contenant (10) est strictement supérieure à une longueur (L1) de l'organe de croissance (100) comptée le long de l'axe principal (X2), de sorte qu'après l'étape d'insertion (E31) du dispositif de diffusion (1) à l'intérieur de l'organe de croissance (100), l'intégralité de la surface de croissance (s101) est en regard d'au moins une partie de la surface externe de l'élément poreux (30).
